# EUROPÄISCHE PATENTSCHRIFT

(11) **EP 0 553 662 B1**
(45) Veröffentlichungstag und Bekanntmachung des Hinweises auf die Patenterteilung: **28.10.1998**
(21) Anmeldenummer: 93100548.2
(22) Anmeldetag: 15.01.1993
(51) Int. Cl.: G03F 7/09, G03F 7/027

(54) **Lichtempfindliches Gemisch zur Herstellung von Relief- und Druckformen**
Photosensitive mixture for production of relief and printing forms
Mélange sensible à la lumière pour production de formes relief et d'impression

(30) Priorität: 29.01.1992 DE 4202332
(43) Veröffentlichungstag der Anmeldung: 04.08.1993
(73) Patentinhaber: BASF Coatings Aktiengesellschaft, 48165 Münster (DE)
(72) Erfinder: Loerzer, Thomas, Dr., W-6730 Neustadt (DE); Telser, Thomas, Dr., W-6940 Weinheim (DE); Zwez, Thomas, Dr., W-7500 Karlsruhe 51 (DE)
(74) Vertreter: Isenbruck, Günter, Dr.

(56) Entgegenhaltungen:
- EP-A- 422 488
- JP-A-63 309 568
- PATENT ABSTRACTS OF JAPAN vol. 8, no. 275 (P-321)(1712) 15. Dezember 1984 & JP-A-59 142 538 ( TOKYO OHKA ) 15. August 1984
- PATENT ABSTRACTS OF JAPAN vol. 10, no. 278 (P-499)(2334) 20. September 1986 & JP-A-61 098 344 ( FUJI ) 16. Mai 1986
- PATENT ABSTRACTS OF JAPAN vol. 12, no. 429 (P-785)(3276) 14. November 1988 & JP-A-63 161 443 ( SUMITOMO ) 5. Juli 1988

## Beschreibung

Die Erfindung betrifft ein lichtempfindliches Gemisch, im wesentlichen bestehend aus einem Blockcopolymerisat aus Styrol, Butadien und/oder Isopren, mindestens einer photopolymerisierbaren, mindestens einfach olefinisch ungesättigten organischen Verbindung, einem Photoinitiator und mindestens einem bestimmten Farbstoff. Dieses Gemisch eignet sich für die Herstellung von Relief- und Druckformen, insbesondere für Flexodruckplatten.

Lichtempfindliche Schichten photopolymerisierbarer Mischungen für die Herstellung von Relief- und Druckformen, insbesondere von Flexodruckplatten, sind vielfach beschrieben worden. Stellt man z.B. mit solchen bekannten Mischungen Flexodruckplatten in den in der Druckindustrie üblichen Reliefstärken von ca. 1.7 bis 6.4 mm her, z.B. nach den DE-A 2138582, 2223808, 2364873, 2610206, 2631837, 2720228, 2815678, EP-A-0 442 488 und den US-Patentschriften 2948611, 3024180, 3674486, 3798035 und 3951657, so zeigen diese einen geringen Belichtungsspielraum, d.h., die Zeit, die notwendig ist, um Gitter, Linien oder Raster zu verankern, ist annähernd gleich groß wie die Zeit, bei denen die Zwischentiefe im negativen i-Punkt eine Untergrenze unterschreitet. Dadurch muß bei der Herstellung der Druckform die Belichtungszeit genau eingehalten werden, um eine optimale Druckform zu erhalten. Andernfalls stehen Gitter, Linien und/oder Raster nicht, bzw. die Zwischentiefen sind ungenügend, so daß beim Drucken z.B. die Rasterflächen schlecht wiedergegeben werden.

Der vorliegenden Erfindung lag die Aufgabe zugrunde, durch kleine Mengen eines Zusatzes einer organischen Verbindung zu Schichten photopolymerisierbarer Mischungen zu erreichen, daß bei der bekannten Herstellung von Reliefformen der Belichtungsspielraum verbessert wird, ohne daß durch die Zusätze die anderen Eigenschaften der photopolymerisierbaren Mischungen bei der Reliefformherstellung wesentlich negativ beeinflußt werden. Bevorzugt sollten diese Zusätze die erforderliche Mindestbelichtungszeit nicht nachteilig verändern. Ganz besonders war gewünscht, Zusätze zu den photopolymerisierbaren Mischungen zu finden, die gleichzeitig durch Änderung des Absorptionsverhaltens eine visuelle Beurteilung der bildmäßig belichteten Form vor dem Entwicklungsschritt ermöglichen, um im Falle von Fehlbelichtungen den zeit- und energieaufwendigen Entwicklungsprozeß zu sparen.

Überraschend wurde gefunden, daß sich lichtempfindliche Schichten, die Gemische aus Blockcopolymerisaten auf Basis Styrol, Butadien und/oder Isopren, photopolymerisierbaren ethylenisch ungesättigten monomeren organischen Verbindungen, Photoinitiator und bestimmten Azofarbstoffen enthalten, vorzüglich für die Herstellung von Relief- und Druckformen, insbesondere Flexodruckplatten eignen, die die gewünschten Verarbeitungseigenschaften und einen deutlich verbesserten Belichtungsspielraum aufweisen.

Gegenstand der vorliegenden Erfindung ist ein lichtempfindliches Gemisch, im wesentlichen bestehend aus
(a) mindestens einem Blockcopolymerisat aus Styrol, Butadien und/oder Isopren,
(b) mindestens einer photopolymerisierbaren mindestens einfach olefinisch ungesättigten organischen Verbindung,
(c) mindestens einem Photoinitiator,
   und
(d) mindestens einem Farbstoff,
das dadurch gekennzeichnet ist, daß das Gemisch als Farbstoff (d) mindestens einen Azofarbstoff einer der allgemeinen Formeln (I) bis (V) enthält 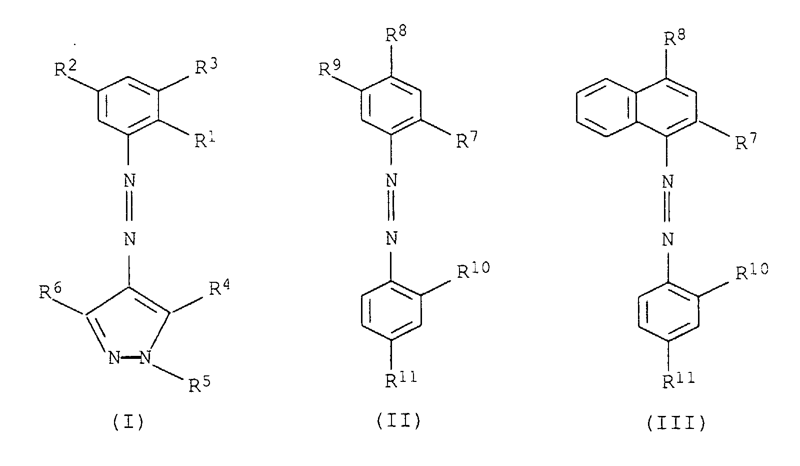 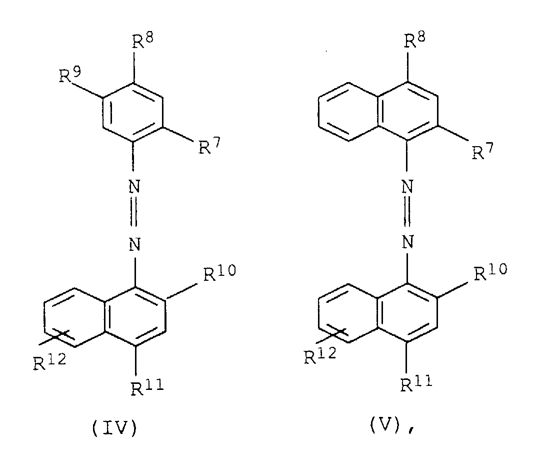 worin
- R¹ =: H, OH, O⁻, COOH oder COO^{-,}
- R² =: H oder NO₂,
- R³ =: H oder SO₃H,
- R⁴ =: H, OH oder O⁻
- R⁵ =: H oder Phenyl,
- R⁶ =: H oder CH₃,
mit der Maßgabe, daß für den Fall R¹ = O⁻ oder COO⁻ und R⁴ = O⁻ jeweils zwei Moleküle der Azofarbstoffe der allgemeinen Formel (I) miteinander über ein Cr⁺⁴-Zentralatom zu einem Cr⁺⁴⁻Komplex verbunden sind,
- R⁷ =: H, CH₃, COOH, COOR mit R = C₁- bis C₁₂-Alkyl, OCH₃ oder NO₂,
- R⁸ =: H, 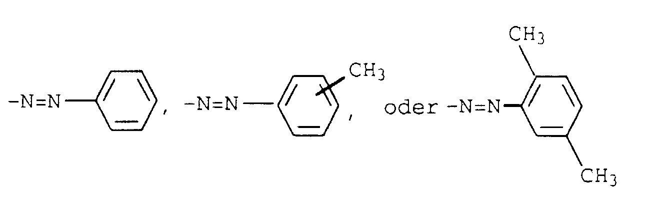
- R⁹ =: H, CH₃, NO₂ oder SO₃H,
- R¹⁰ =: H, OH, NH₂, NHR oder NR₂ mit R = C₁- bis C₁₂-Alkyl,
- R¹¹ =: H, OH, NH₂, NHR oder NR₂ mit R = C₁- bis C₁₂-Alkyl,
- R¹² =: H, C₁- bis C₁₂-Alkyl oder SO₃H.

Das erfindungsgemäße lichtempfindliches Gemisch enthält vorzugsweise
60 bis 90 Gewichtsteile der Komponente (a),
1 bis 20 " " " (b),
0,01 bis 10 " " " (c)
   und
0,001 bis 0,1 " " " (d)

Gegenstand der vorliegenden Erfindung ist außerdem ein Verfahren zur Herstellung von Relief- und Druckformen durch bildmäßiges Belichten einer auf einen Träger aufgebrachten lichtempfindlichen Schicht mit aktinischem Licht und Entwikkeln der Reliefform durch Auswaschen der unbelichteten Schichtanteile, das dadurch gekennzeichnet ist, daß die lichtempfindliche Schicht im wesentlichen aus dem lichtempfindlichen Gemisch gemäß der vorliegenden Erfindung besteht.

Das erfindungsgemäße Verfahren eignet sich zur Herstellung von Reliefhochdruckformen, insbesondere zur Herstellung von Flexodruckformen.

Besondere Vorteile der erfindungsgemäßen lichtempfindlichen Gemische sind die damit erhältliche verbesserte Bildwiedergabe sowie die verbesserte Ausbildung von Zwischentiefen bei der Reliefformherstellung.

Zu den Aufbaukomponenten der erfindungsgemäßen lichtempfindlichen Gemischen ist im einzelnen folgendes auszuführen.

Als Komponente (a) enthalten die erfindungsgemäßen lichtempfindlichen Gemische mindestens ein Blockcopolymerisat aus Styrol und Butadien und/oder Isopren, beispielsweise Styrol/ Isopren/Styrol-Copolymerisate. Derartige geeignete Blockcopolymerisate und deren Herstellung sind z.B. beschrieben in Cunningham, R.E., et al., J. Appl. Polymer Sci., 12, 1 (1968). Die Monomerverhältnisse im Blockcopolymerisat liegen im allgemeinen bei 10-30 Gewichtsprozent Styrol und 70-90 Gewichtsprozent Butadien oder Isopren oder 70-90 Gewichtsprozent eines Butadien/Isoprengemisches. Die Shore-A-Werte der Blockcopolymerisate liegen zwischen etwa 30 und 70.

Komponente (a) ist im erfindungsgemäßen lichtempfindlichen Gemisch im allgemeinen in Mengen von 60 bis 90, vorzugsweise 70 bis 80 Gewichtsteilen enthalten. Bevorzugt als Komponente (a) sind Blockcopolymerisate aus 15-20 Gewichtsprozent Styrol und 80-85 Gewichtsprozent Isopren, Butadien oder Butadien/Isoprengemisch.

Als Komponente (b) eignen sich die üblichen photopolymerisierbaren ein- oder mehrfach ethylenisch ungesättigten organischen Verbindungen, wie sie für die Herstellung photopolymerer Druckplatten eingesetzt werden und mit der Komponente (a) verträglich sind. Als Beispiele für die Komponente (b) seien genannt die Ester der Acrylsäure und/oder Methacrylsäure mit ein- oder mehrwertigen Alkoholen, wie Butyl(meth)acrylat, 2-Ethyl-hexyl(meth)acrylat, Lauryl(meth)acrylat, Ethylenglykoldimethacrylat, Butandiol-1,4-di(meth)acrylat, Neopentylglykoldimethacrylat, Hexandioldi(meth)acrylat, 2-Hydroxyethylmethacrylat, 3-Methylpentandioldiacrylat, 2-Hydroxypropylacrylat, 1,1,1-Trimethylolpropantri(meth)acrylat, Di, -Tri- und Tetraethylenglykoldiacrylat, Tripropylenglykoldiacrylat, Pentaerythrittetraacrylat. Geeignet sind auch Vinylester aliphatischer Monocarbonsäuren wie Vinyloleat und Vinylether von Alkoholen wie Octadecylvinylether oder Butandiol-1,4-divinylether. Durch geeignete Wahl der Monomeren und Mischungen von ihnen können die Eigenschaften der erfindungsgemäßen photopolymerisierbaren Gemische für den speziellen Zweck modifiziert werden.

Komponente (b) ist im erfindungsgemäßen lichtempfindlichen Gemisch im allgemeinen in Mengen von 1 bis 20, vorzugsweise 5 bis 12 Gewichtsteilen im erfindungsgemäßem lichtempfindlichen Gemisch vorhanden.

Als Komponente (c) enthält das erfindungsgemäße lichtempfindliche Gemisch einen oder mehrere Photoinitiatoren in Mengen von 0,01 bis 10, vorzugsweise 0,01 bis 5 Gewichtsteilen.

Beispiele für geeignete Photoinitiatoren (c) sind aromatische Ketoverbindungen, wie Benzoin, Benzoinderivate, wie dessen Methyl-, Isopropyl-, n-Butyl- oder Isobutylether, symmetrisch oder unsymmetrisch substituierte Benzilketale, wie Benzildimethylketal.

Als Komponente (d) enthält das erfindungsgemäße lichtempfindliche Gemisch einen oder mehrere Azofarbstoffe der allgemeinen Formeln (I) bis (V) 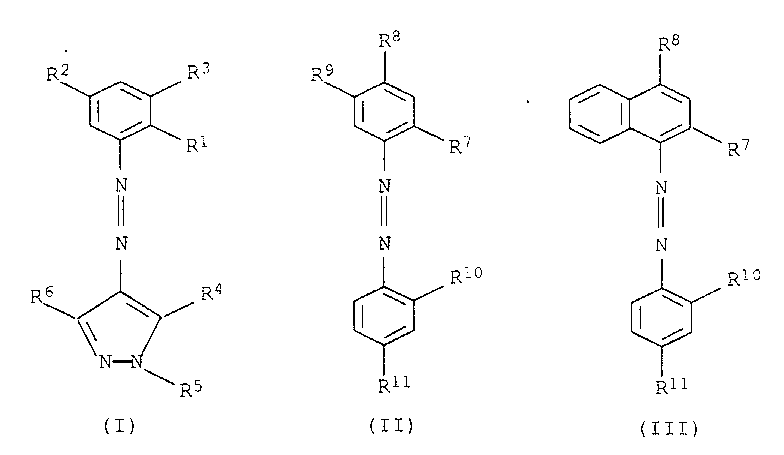 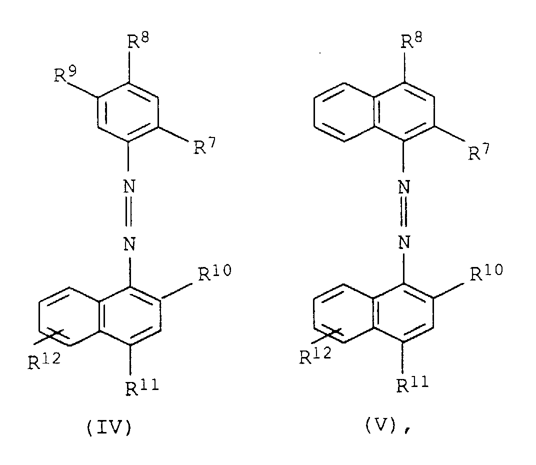 worin
- R¹ =: H, OH, O⁻, COOH oder COO⁻,
- R² =: H oder NO₂,
- R³ =: H oder SO₃H,
- R⁴ =: H, OH oder O⁻
- R⁵ =: H oder Phenyl,
- R⁶ =: H oder CH₃,
mit der Maßgabe, daß für den Fall R¹ = O⁻ oder COO⁻ und R⁴ = O⁻ jeweils zwei Moleküle der Azofarbstoffe der allgemeinen Formel (I) miteinander über ein Cr⁺⁴-Zentralatom zu einem Cr⁺⁴-Komplex verbunden sind,
- R⁷ =: H, CH₃, COOH, COOR mit R = C₁- bis C₁₂-Alkyl, vorzugsweise C₁- bis C₄-Alkyl, wie z.B. Methyl, Ethyl, n-Propyl, Isopropyl, n-Butyl, Isobutyl, t-Butyl, OCH₃ oder NO₂,
- R⁸ =: H, 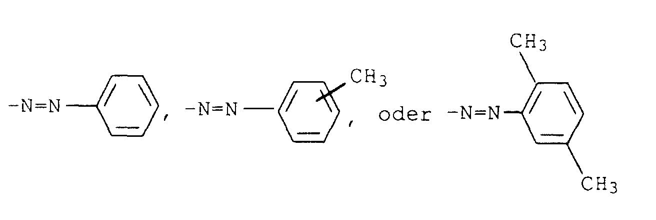
- R⁹ =: H, CH₃, NO₂ oder SO₃H,
- R¹⁰ =: H, OH, NH₂, NHR oder NR₂ mit R = C₁- bis C₁₂-Alkyl, vorzugsweise C₁- bis C₄-Alkyl, wie z.B. Methyl, Ethyl, n-Propyl, Isopropyl, n-Butyl, Isobutyl, t-Butyl,
- R¹¹ =: H, OH, NH₂, NHR oder NR₂ mit R = C₁- bis C₁₂-Alkyl, vorzugsweise C₁- bis C₄-Alkyl, wie z.B. Methyl, Ethyl, n-Propyl, Isopropyl, n-Butyl, Isobutyl, t-Butyl,,
- R¹² =: H, C₁- bis C₁₂-Alkyl, vorzugsweise C₁- bis C₄-Alkyl, wie z.B. Methyl, Ethyl, n-Propyl, Isopropyl, n-Butyl, Isobutyl, t-Butyl, oder SO₃H

Es können auch Gemische von unter die allgemeine Formeln (I) bis (V) fallenden Azofarbstoffen eingesetzt werden. Komponente (d) ist im erfindungsgemäßen lichtempfindlichen Gemisch in Mengen von 0,001 bis 0,1, vorzugsweise 0,005 bis 0,02 Gewichtsteilen im lichtempfindlichen Gemisch enhalten.

Das erfindungsgemäße lichtempfindliche Gemisch kann noch weitere für die Druckplattenherstellung übliche Zusatzstoffe in untergeordneten Mengen von bis zu 20 Gewichtsteilen enthalten.

Zur Verhinderung der thermischer Polymerisation der Monomeren (b) können die erfindungsgemäßen Gemische Inhibitoren wie p-Methoxyphenol, Hydrochinon, 2,6-Di-tert.-butyl-4-methylphenol oder andere handelsübliche Inhibitoren enthalten. Voraussetzung für die Auswahl derartiger Inhibitoren ist das Fehlen einer nennenswerten Eigenabsorption im aktinischen Bereich, in dem der gleichzeitig verwendete Photoinitiator absorbiert.

Zur Steuerung der Härte der erfindungsgemäßen lichtempfindlichen Gemische können allgemein aus der Kautschukverarbeitung bekannte Zusätze, wie Weichmacher angewendet werden. Beispielsweise ergibt der Zusatz von als Weichmacher wirkenden Paraffinölen in bestimmten Mengen weichelastische Schichten mit gutem Rückstellverhalten. Zusätze von Oligomerstyrol, niedermolekularen Styrolcopolymerisaten, statistischen Styrol/Butadien-Copolymerisaten mit hohen Styrolgehalten und von α-Methylstyrol-Copolymerisaten erhöhen die Härte der belichteten Schichten.

Die erfindungsgemäßen Gemisch zeichnen sich durch ihre gute Verarbeitbarkeit bei der Herstellung von Schichten aus. Die Gemische können nach bekannten Verfahren hergestellt und zu Schichten gewünschter Schichtdicke verarbeitet werden. Beispielsweise können Schichten der Gemische aus Lösungen in geeigneten Lösungsmitteln (Toluol, Methylisobutylketon, Cyclohexan) durch Gießen auf entsprechende Schichtträger hergestellt werden. Ebenso können derartige Schichten durch Pressen, Extrudieren und Kalandrieren hergestellt werden.

Die Schichtstärke ist je nach Anwendungszweck leicht variabel, für lichtempfindliche Aufzeichnungselemente wie Flexodruckplatten wird sie zwischen 0,01 und 6,5 mm Dicke variiert.

Als Schichtträger für die erfindungsgemäßen lichtempfindlichen Gemische eignen sich flexible Materialien wie Folien aus Polyethylenterephthalat, Polybutylenterephthalat, Polycarbonat mit ausreichend hohem Elastizitätsmodul, um als dimensionsstabiles Trägermaterial geeignet zu sein.

Als Haftschichten zwischen Schichten der erfindungsgemäßen lichtempfindlichen Gemische und Schichtträgern können handelsübliche Ein- oder Zweikomponentenkleber verwendet werden, deren Art sich nach dem Schichtträgermaterial und nach den aufzubringenden photopolymerisierbaren Schichten richtet. Als häufig geeignete Kleber seien die handelsüblichen Reaktionskleber auf Polyurethan- und auf Polychloropren-Basis genannt, die durch Substrieren oder Gießen in geeigneter Schichtdicke auf die zu verbindenden Schichten aufgebracht werden können.

Es ist oft von Vorteil, auf die Schicht aus dem erfindungsgemäßen Gemisch noch eine haftfest verbundene, dünne, klebfreie Überzugsschicht aufzubringen, die bevorzugt aus einem harte, klebfreie, transparante und reißfeste Filme bildenden Polymeren, z.B. einem im Entwickler löslichen Polyamid, Copolyamid, Polyurethan oder Cyclokautschuk mit hohem Cyclisierungsgrad besteht. Die Stärke dieser Überzugsschicht beträgt zweckmäßigerweise etwa 0,5 bis 20 µm. Durch diese Überzugsschicht ist z.B. eine klebfreie, blasenfreie Negativauflage bei der Reliefdruckplattenherstellung möglich, die in manchen Fällen ohne diese wegen einer Oberflächenklebrigkeit der Schicht aus dem photopolymerisierbaren Gemisch nicht möglich ist. Bei der Entwicklung der belichteten Anteile der Schicht zur Reliefschicht wird im allgemeinen die Überzugsschicht mit unvernetzten Schichtanteilen weggewaschen.

Es ist ferner oft vorteilhaft, die Überzugsschicht noch mit einer abziehbaren Schutzfolie, wie einer Polyesterfolie zu versehen, wobei diese auch zusammen mit der Überzugsschicht auf die photopolymerisierbare Schicht aufgebracht werden kann. Die Schutzfolie wird im allgemeinen vor der bildmäßigen Belichtung abgezogen, während die Überzugsschicht dabei im allgemeinen auf der Schicht verbleibt.

In an sich bekannter Weise können Schichten der erfindungsgemäßen lichtempfindlichen Gemische durch bildmäßiges Belichten der Schicht und anschließendes Entfernen, insbesondere Auswaschen der unbelichteten bzw. unvernetzten Schichtanteile mit einem Entwicklerlösemittel zu Reliefformen verarbeitet werden, die für den Flexodruck besonders geeignet sind. Für die Belichtung, die in Form einer Flach- oder Rundbelichtung erfolgen kann, eignen sich die üblichen Lichtquellen von aktinischem Licht, wie handelsübliche UV-Fluoreszenzröhren oder Quecksilberhochdrucklampen. Die emittierte Wellenlänge sollte bevorzugt bei 300 bis 400 nm liegen, bzw. auf die Eigenabsorption des in der photopolymerisierbaren Schicht enthaltenen Photoinitiators abgestimmt sein. Beispiele geeigneter Entwicklerlösungsmittel für das Auswaschen der unvernetzten Anteile der Schicht zur Reliefentwicklung sind chlorierte Kohlenwasserstoffe, wie z.B. Tetrachlorethan, Kohlenwasserstoffe, wie z.B. hydrierte Erdölfraktionen, oder andere organische Lösungsmittel, wie z.B. Methylisobutylketon oder Mischungen solcher Lösungsmittel mit niederen Alkoholen zur Steuerung der Auswaschwirkung.

Die in den Beispielen genannten Teile und Prozente beziehen sich, soweit nicht anders angegeben, auf das Gewicht.

Herstellung eines Gemisches der Komponenten (a) bis (c) unter Mitverwendung eines Weichmachers und eines Inhibitors gegen die thermische Polymerisation (= Gemisch A):

Es wurde ein Gemisch aus 80 Teilen eines Styrol/Isopren/Styrol-Dreiblockpolymeren (z.B. Cariflex® TR 1107 [aus 15 Gewichtsprozent Styrol und 85 Gewichtsprozent Isopren] der Fa. Deutsche Shell Chemie GmbH), 10 Teilen Hexandioldiacrylat, 10 Teilen Hexandioldimethacrylat, 10 Teilen eines Weißöls, welches 60 % paraffinisch gebundenen und 40 % naphthenisch gebunden Kohlenstoff enthält, 0,7 Teilen 2,6-Di-tert.-butylkresol und 0,7 Teilen Benzildimethylketal hergestellt.

### Vergleichsbeispiel 1 (=V1)

Aus Gemisch A wurde ohne weitere Zusätze eine Flexo-Rohplatte mit einer Schichtdicke von 2,84 mm hergestellt. Zur Beurteilung der Belichtungseigenschaften wurde eine Belichtungsreihe in 3 min-Schritten erstellt. Als Belichter diente der nyloflex®-FIII-Flachbelichter der BASF L + F Aktiengesellschaft; zum Entwickeln wurde der nyloflex-FIII-Durchlaufwascher der BASF L + F Aktiengesellschaft mit nylosolv® (= Gemisch aus 80 Gew.% einer hydrierten Erdölfraktion und 20 Gew.% Pentanol) als Entwicklerlösungsmittel eingesetzt. Die Verarbeitung erfolgte gemäß der Arbeitsanleitung für nyloflex® FA (BASF Aktiengesellschaft, Ludwigshafen, Abt. Reproduktionstechnik).

Die erhaltenen Belichtungseigenschaften sind in Tabelle 2 unter V1 aufgeführt.

### Vergleichsbeispiel 2 (=V2)

In das Gemisch A wurden 120 ppm Rhodamin 3 GO (CI Basic Red 4) homogen eingemischt. Damit wurde eine Flexo-Rohplatte mit einer Schichtdicke von 2,84 mm hergestellt. Die Weiterverarbeitung und Prüfung erfolgte wie in V1 beschrieben. Die damit erhaltenen Belichtungseigenschaften sind in Tabelle 2 unter V2 aufgeführt.

### Vergleichsbeispiel 3 (= V3)

In das Gemisch A wurden 120 ppm Victoria Reinblau BO (CI Basic Blue 7) homogen eingemischt. Die Weiterverarbeitung und Prüfung erfolgte wie in V2 beschrieben. Die Belichtungseigenschaften sind in Tabelle 2 unter V3 angegeben.

### Vergleichsbeispiel 4 (= V4)

In das Gemisch A wurden 120 ppm Anthrachinonblau 2 GA (CI Acid Blue 7) homogen eingemischt. Die Weiterverarbeitung und Prüfung erfolgte wie in V2 beschrieben. Die Belichtungseigenschaften sind in Tabelle 2 unter V4 angegeben.

### Beispiele 1 bis 10

In das Gemisch A wurden die unter 1 bis 10 in Tabelle 1 angegebenen Azofarbstoffe jeweils in Mengen von 120 ppm homogen eingemischt. Die Weiterverarbeitung und Prüfung erfolgte wie in V2 beschrieben. Die Belichtungseigenschaften sind in Tabelle 2 unter B1 bis B10 angegeben.

**Tabelle 1:**

| Nr . | Formel | R¹ | R² | R³ | R⁴ | R⁵ | R⁶ |
|---|---|---|---|---|---|---|---|
| 1 | (I) Cr⁺⁴ | O⁻ | NO₂ | H | O⁻ | Phenyl | CH₃ |
| 2 | (I) Cr⁺⁴ | COO⁻ | H | H | O⁻ | Phenyl | CH₃ |
| 3 | (I) Cr⁺⁴ | O⁻ | NO₂ | SO₃H | O⁻ | Phenyl | CH₃ |
| 4 | (I) Cr⁺⁴ | COO⁻ | H | H | O⁻ | Phenyl | CH₃ |
| 5 | (I) | H | H | H | OH | Phenyl | CH₃ |
| | | | | | | | |

| Nr. | Formel | R¹⁰ | R¹¹ | R¹² | R⁷ | R⁸ | R⁹ |
|---|---|---|---|---|---|---|---|
| 6 | (II) | NH₂ | NH₂ | - | H | H | H |
| 7 | (IV) | OH | H | CH₃ | CH₃ | 2-CH₃-phenylazo | H |
| 8 | (IV) | OH | H | - | CH₃ | 2-CH₃-phenylazo | H |
| 9 | (IV) | OH | H | - | OCH₃ | H | H |
| 10 | (IV) | OH | H | - | H | H | H |

**Tabelle 2**

| Beispiel/Vergleichsbeispiel | Farbstoff: | Konz. ppm | VBZ sec | UBG min | OBG min | BLS min |
|---|---|---|---|---|---|---|
| V1 | - | 0 | 15 | 9 | 12 | 3 |
| V2 | Rhodamin 3 GO | 120 | 30 | 12 | 12 | 0 |
| | | | | | | |
| V3 | Victoria Reinblau BO | 120 | 40 | 9 | 12 | 3 |
| | | | | | | |
| V4 | Anthrachinonblau 2 GA | 120 | 25 | 9 | 9 | 0 |
| | | | | | | |
| B1 | Nr. 1 | 120 | 60 | 9 | 18 | 9 |
| B2 | Nr. 2 | 120 | 60 | 9 | 18 | 9 |
| B3 | Nr. 3 | 120 | 30 | 9 | 18 | 9 |
| B4 | Nr. 4 | 120 | 50 | 9 | 18 | 9 |
| B5 | Nr. 5 | 120 | 180 | 9 | 18 | 9 |
| B6 | Nr. 6 | 120 | 200 | 9 | 18 | 9 |
| B7 | Nr. 7 | 120 | 45 | 9 | 21 | 12 |
| B8 | Nr. 8 | 120 | 60 | 12 | 30 | 28 |
| B9 | Nr. 9 | 120 | 60 | 9 | 21 | 12 |
| B10 | Nr. 10 | 120 | 140 | 9 | 30 | 21 |
| VBZ = "Vorbelichtungszeit", die notwendig ist, um eine Relieftiefe von 0,7 mm zu erhalten. UBG = "untere Belichtungsgrenze" ist diejenige Zeit, bei der a) ein Liniengitter aus 55 µm-Linien, b) freistehende Punkte mit einem Durchmesser von 250 µm und c) ein Raster von 3 % Tonwert gut versockelt sind, bei Relieftiefen bis 0,7 mm. OBG = "obere Belichtungsgrenze" ist die Zeit, bei der die Zwischentiefe eines negativen Punkte von 400 µm Durchmesser mindestens 70 µm beträgt. BLS = "Belichtungsspielraum" ist die Differenz aus OBG und UBG. | | | | | | |

## Patentansprüche

1. Lichtempfindliches Gemisch, im wesentlichen bestehend aus
(a) mindestens einem Blockcopolymerisat aus Styrol, Butadien und/oder Isopren,
(b) mindestens einer photopolymerisierbaren mindestens einfach olefinisch ungesättigten organischen Verbindung,
(c) mindestens einem Photoinitiator,
und
(d) mindestens einem Farbstoff,
dadurch gekennzeichnet, daß das Gemisch als Farbstoff (d) mindestens einen Azofarbstoff einer der allgemeinen Formeln (I) bis (V) enthält 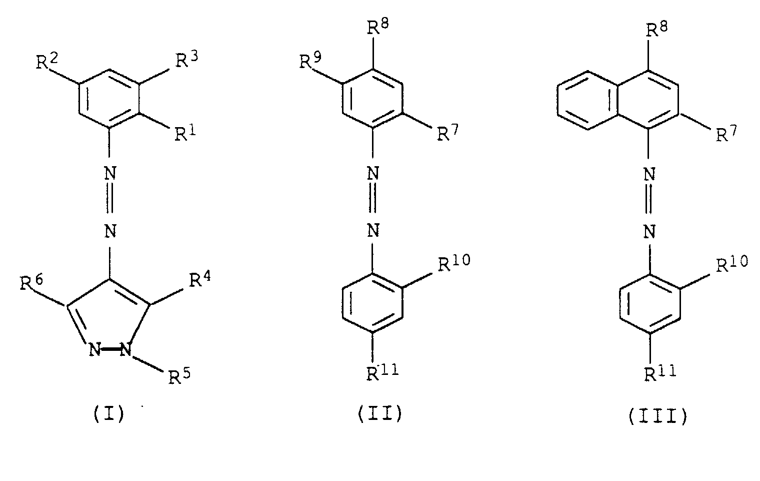 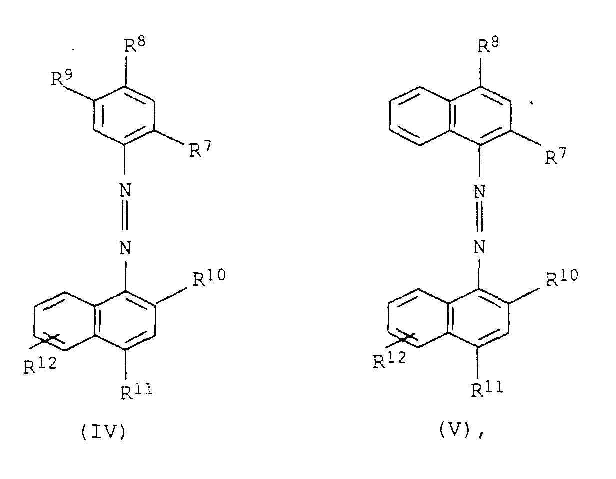 worin
R¹ = H, OH, O⁻, COOH oder COO⁻
R² = H oder NO₂,
R³ = H oder SO₃H,
R⁴ = H, OH oder O⁻
R⁵ = H oder Phenyl,
R⁶ = H oder CH₃,
mit der Maßgabe, daß für den Fall R¹ = O⁻ oder COO⁻ und R⁴ = O⁻ jeweils zwei Moleküle der Azofarbstoffe der allgemeinen Formel (I) miteinander über ein Cr⁺⁴-Zentralatom zu einem Cr⁺⁴-Komplex verbunden sind,
R⁷ = H, CH₃, COOH, COOR mit R = C₁- bis C₁₂-Alkyl, OCH₃ oder NO₂,
R⁸ = H, 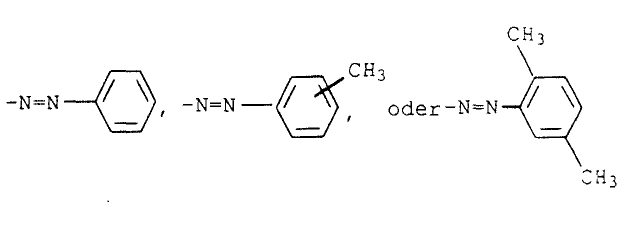
R⁹ = H, CH₃, NO₂ oder SO₃H,
R¹⁰ = H, OH, NH₂, NHR oder NR₂ mit R = C₁- bis C₁₂-Alkyl,
R¹¹ = H, OH, NH₂, NHR oder NR₂ mit R = C₁- bis C₁₂-Alkyl,
R¹² = H, C₁- bis C₁₂-Alkyl oder SO₃H.

2. Lichtempfindliches Gemisch nach Anspruch 1, dadurch gekennzeichnet,
daß es 60 bis 90 Gewichtsteile der Komponente (a),
1 bis 20 " " " (b),
0,01 bis 10 " " " (c)
und
0,001 bis 0,1 " " " (d)
enthält.

3. Lichtempfindliches Gemisch nach Anspruch 1 oder 2, dadurch gekennzeichnet, daß es einen Zusatz eines Weichmachers und/oder eines Inhibitors gegen die thermische Polymerisation enthält.

4. Verfahren zur Herstellung von Relief- und Druckformen durch bildmäßiges Belichten einer auf einen Träger aufgebrachten lichtempfindlichen Schicht mit aktinischem Licht und Entwickeln der Reliefform durch Auswaschen der unbelichteten Schichtanteile, dadurch gekennzeichnet, daß die lichtempfindliche Schicht im wesentlichen aus dem lichtempfindlichen Gemisch gemäß einem der vorhergehenden Ansprüche besteht.

## Claims

1. A photosensitive mixture consisting essentially of
(a) at least one block copolymer of styrene, butadiene and/or isoprene,
(b)at least one photopolymerizable olefinically at least monounsaturated organic compound,
(c)at least one photoinitiator, and
(d)at least one dye,
wherein said dye (d) comprises at least one azo dye of one of the general formulae (I) to (V) 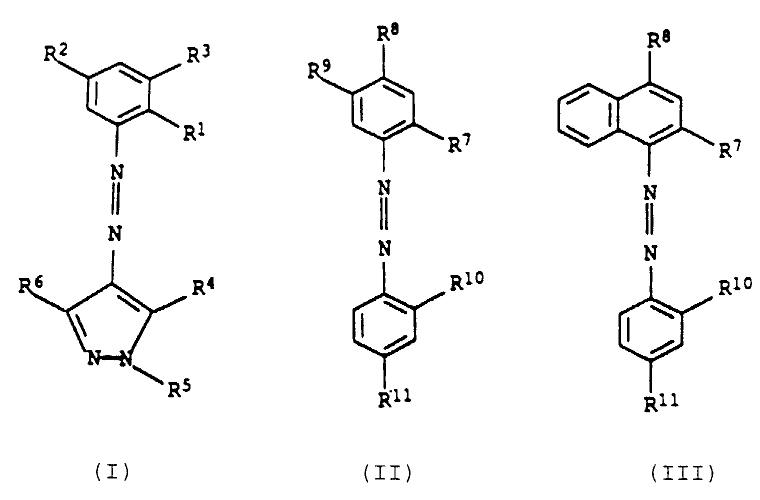 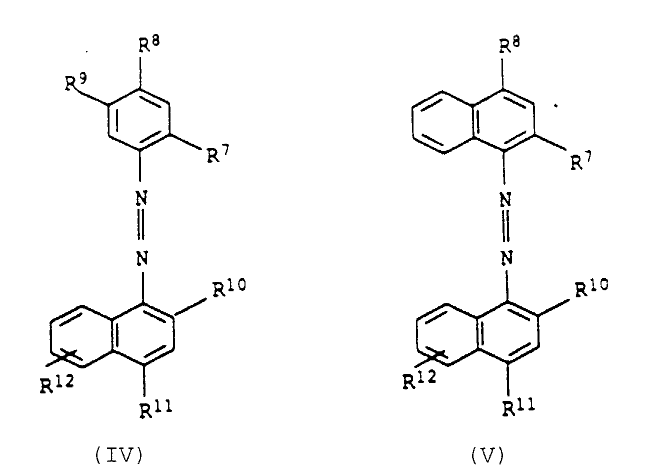 where
R¹ = H, OH, O⁻, COOH or COO⁻,
R² = H or NO₂,
R³ = H or SO₃H,
R⁴ = H, OH or O⁻,
R⁵ = H or phenyl,
R⁶ = H or CH₃,
with the proviso that if R¹ = O⁻ or COO⁻ and R⁴ = O⁻ two molecules of the azo dyes of the general formula (I) combine with one another via a Cr⁺⁴ central atom to form a Cr⁺⁴ complex,
R⁷ = H, CH₃, COOH, COOR where R = C₁- to C₁₂-alkyl, OCH₃ or NO₂,
R⁸ = H, 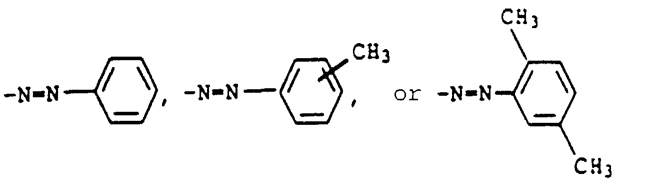
R⁹ = H, CH₃, NO₂ or SO₃H,
R¹⁰ = H, OH, NH₂, NHR or NR₂ where R = C₁- to C₁₂-alkyl,
R¹¹ = H, OH, NH₂, NHR or NR₂ where R = C₁- to C₁₂-alkyl,
R¹² = H, C₁- to C₁₂-alkyl or SO₃H.

2. A photosensitive mixture as claimed in claim 1, comprising
from 60 to 90 parts by weight of component (a),
from 1 to 20 " " " " " (b),
from 0.01 to 10 " " " " " (c)
and
from 0.001 to 0.1 part by weight of component (d).

3. A photosensitive mixture as claimed in claim 1 or 2, comprising a plasticizer and/or a thermal polymerization inhibitor.

4. The process for producing relief and printing plates by subjecting a supported photosensitive layer to imagewise exposure under actinic light and developing the relief plate by washing out the nonirradiated parts of the layer, wherein the photosensitive layer consists essentially of the photosensitive mixture of any one of the preceding claims.

## Revendications

1. Mélange sensible à la lumière, constitué essentiellement
(a) d'au moins un copolymère séquencé formé à partir de styrène, de butadiène et/ou d'isoprène,
(b) d'au moins un composé organique photopolymérisable ayant au moins une insaturation oléfinique simple,
(c) d'au moins un photoamorceur et
(d) d'au moins un colorant,
caractérisé en ce que le mélange contient en tant que colorant (d), au moins un colorant azoïque d'une des formules générales (I) à (v) 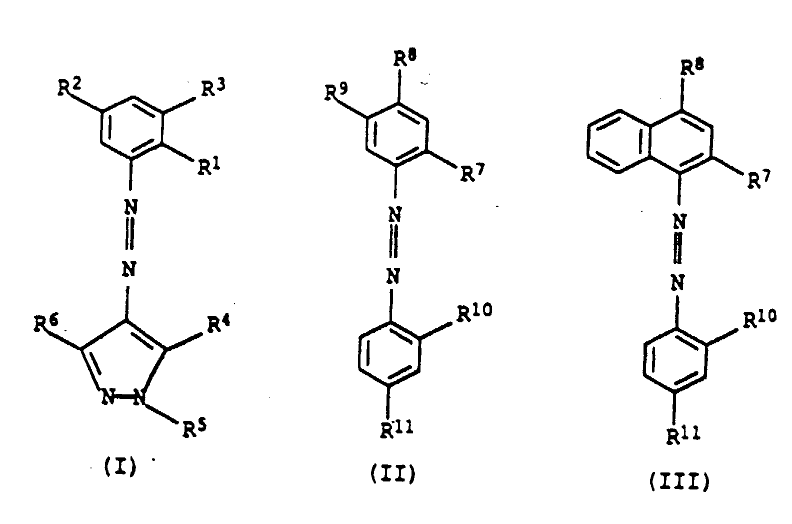 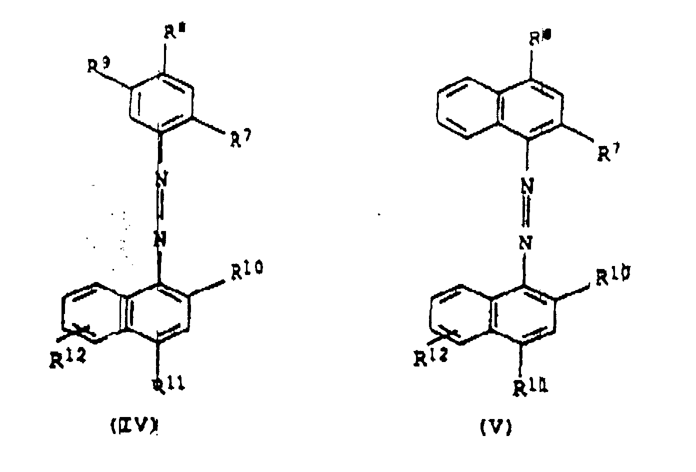 dans lesquelles
R¹ = H, OH, O⁻, COOH ou COO⁻
R² = H ou NO₂,
R³ = H ou SO₃H
R⁴ = H, OH ou O⁻,
R⁵ = H ou un groupement phényle,
R⁶ = H ou un groupement CH₃,
étant spécifié que lorsque R¹ = O⁻ ou COO⁻ et R⁴ = O⁻, deux molécules du colorant azoïque de formule générale (I) sont reliées entre elles à chaque fois par un atome central de Cr⁴⁺ en un complexe de Cr⁴⁺,
R⁷ = H, CH₃, COOH, COOR avec R = un groupement alkyle en C₁-C₁₂, OCH₃ ou NO₂
R⁸ = H, 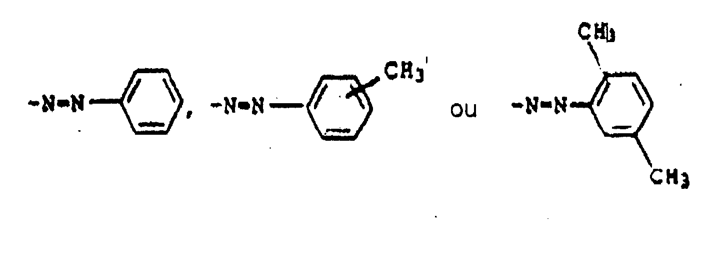
R⁹ = H, CH₃, NO₂ ou SO₃H,
R¹⁰ = H, OH, NH₂, NHR ou NR₂ avec R = un groupement alkyle en C₁-C₁₂,
R¹¹ = H, OH, NH₂, NHR ou NR₂ avec R = un groupement alkyle en C₁-C₁₂,
R¹² = H, un groupement alkyle en C₁-C₁₂ ou SO₃H.

2. Mélange sensible à la lumière selon la revendication 1, caractérisé en ce qu'il contient
| | |
|---|---|
| 60-90 | parties en poids du composant (a), |
| 1-20 | parties en poids du composant (b), |
| 0,01-10 | parties en poids du composant (c), |
| 0,001-0,1 | partie en poids du composant (d). |

3. Mélange sensible à la lumière selon la revendication 1 ou 2, caractérisé en ce qu'il contient un ajout d'un agent de blanchiment et/ou d'un inhibiteur de polymérisation thermique.

4. Procédé de préparation de moules à relief et de matrices par exposition à une lumière actinique formant une image, d'une couche sensible à la lumière déposée sur un support, et révélation du moule à relief par élimination par lavage de la partie de la couche non soumise à l'exposition, caractérisé en ce que la couche sensible à la lumière est essentiellement constituée du mélange sensible à la lumière selon l'une quelconque des revendications 1 à 3.
